# EUROPEAN PATENT APPLICATION

(11) **EP 4 617 678 A1**
(43) Date of publication of application: **17.09.2025**
(21) Application number: 24305369.1
(22) Date of filing: 11.03.2024
(51) Int. Cl.: G01R 15/18, G01R 15/20, H03K 17/082

(54) **IMPROVED ELECTRONIC POWER DEVICE**

(71) Applicant: ALSTOM Holdings, 93400 Saint-Ouen-sur-Seine (FR)
(72) Inventor: ESCROUZAILLES, Vincent, 65601 SEMEAC CEDEX (FR); BATISTA, Emmanuel, 65000 TARBES (FR); DUMOLLARD, Yannick, 65601 SEMEAC CEDEX (FR)
(74) Representative: Plasseraud IP

(57) **Abstract**

The electronic power device (2) comprises a first power switch (S1) and a second power switch (S2) connected in series between first (6) and second (8) connection terminals of the device (2), and a detection apparatus comprising at least one coil (12) associated with the first and second connection terminals, and an electronic processing circuit (14) configured to detect an electrical voltage measured by said coil (12). The coil (12) is mounted on a printed circuit board (16) adjacent said first (6) and second (8) connection terminals and aligned, substantially in the same geometric plane as said printed circuit board (16). The coil (12) is configured to measure the magnetic field existing between said terminals (6, 8) in said plane (P1).

## Description

The present invention relates to an electronic power device.

An electronic power device is already known from EP 3 748 850. This known electronic power device, comprises:
- a first power switch and a second power switch connected in series between first and second connection terminals of the device,
- a detection apparatus comprising at least one coil associated with the first and second connection terminals, and an electronic processing circuit configured to detect an electrical voltage measured by said coil.

The invention is intended to improve such an electronic power device, by allowing to capture current image without any impact on power circuit and without drawback on switching performances.

To this end, the invention relates to an electronic power device, comprising:
- a first power switch and a second power switch connected in series between first and second connection terminals of the device,
- a detection apparatus comprising at least one coil associated with the first and second connection terminals, and an electronic processing circuit configured to detect an electrical voltage measured by said coil,

characterized in that said coil is mounted on a printed circuit board adjacent said first and second connection terminals and aligned, substantially in the same geometric plane as said printed circuit board,
and in that the coil is configured to measure the magnetic field existing between said terminals in said plane.

The device of the invention is based on magnetic coupling between an internal first circuit of the power device and the coupling coil arranged directly on the Printed Circuit Board on top of the module and between terminals. Current variation through the internal circuit generate magnetic field, which is transformed by the coupling coil in a resulting voltage. Using this voltage information, it will be possible to get different information such as the current variation di/dt, the current level, the power supply level, etc.

This system does not need to be supplied, which make integration easier.

A power device according to the invention may comprise any of the following features, taken alone or in any possible combination:
- The electronic power device comprises a housing in which the first and second switches are housed, and including a main face on which the first and second connection terminals are arranged, the printed circuit board being arranged on said main face.
- The first terminal comprises two first contact pads, and the second terminal comprises two second contact pads.
- The coil is arranged in an area delimited by the two first contact pads and the two second contact pads.
- The coil is aligned with the printed circuit board or mounted on its surface.
- The printed circuit board comprises two recesses each of a shape complementary to the shape of a portion of the housing on which the first contact pads are mounted.
- The printed circuit board comprises a pad protruding between the two recesses, the coil being arranged on the pad.

Several aspects and advantages of the invention will be enlightened in the following disclosure, given only as an example and made with reference to the appended drawings, in which:
- Figure 1 is a simplified electrical diagram of a device according to an example of embodiment of the invention;
- Figure 2 is a perspective view of the device of Figure 1.

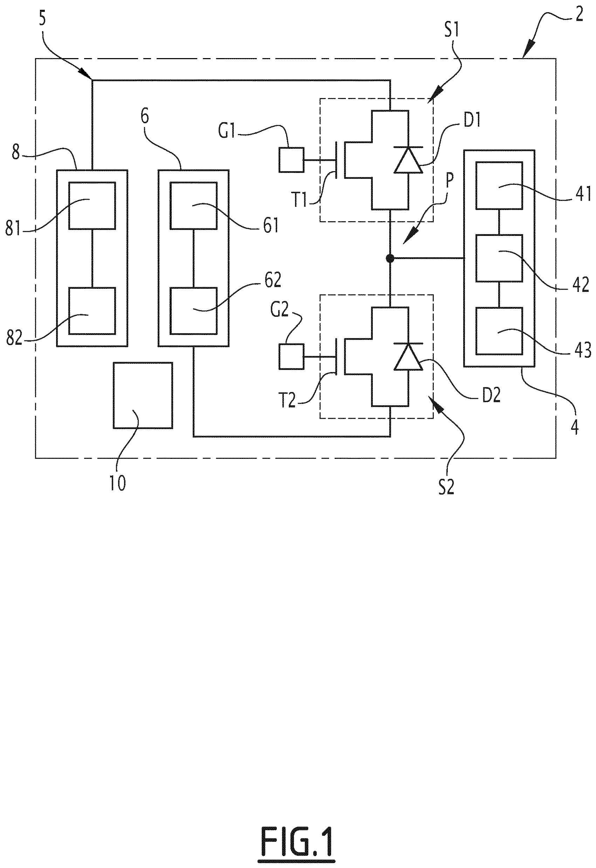

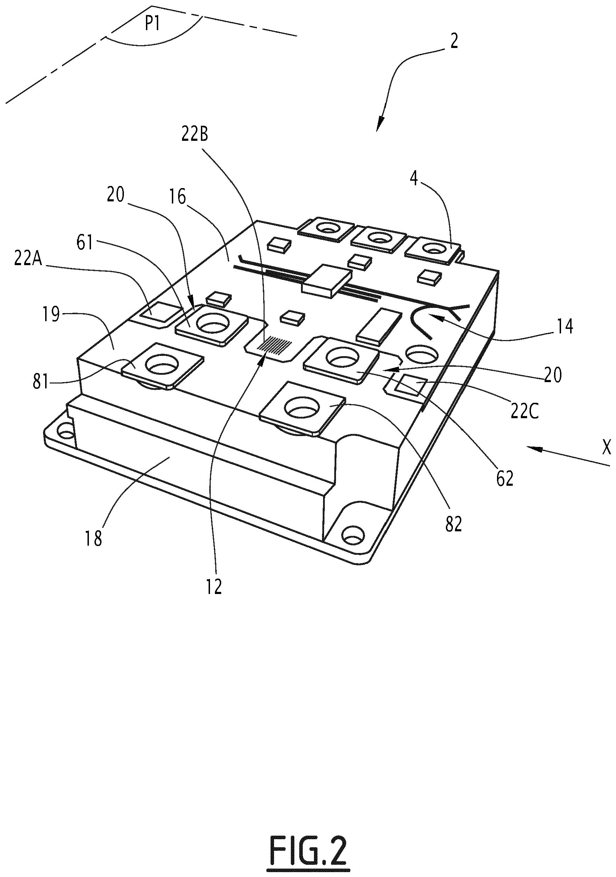

An electronic power device 2 is shown on Figures 1 and 2. The device 2 is for example intended to be used in an electrical circuit or an electrical system, such as a power converter.

The device 2 comprises a first circuit 5 including a first power switch S1 and a second power switch S2 connected in series between a first connection terminal 6 and a second connection terminal 8 of the device 2, such as a positive terminal and a negative terminal.

For example, the first power switch S1 and the second power switch S2 each include a power transistor, respectively denoted T1 and T2. Advantageously, the power transistors T1 and T2 can be MOSFET transistors (Metal-Oxide Semiconductor Field-Effect Transistor), or alternatively IGBT transistors (Insulated Gate Bipolar Transistor), or bipolar transistors, or any other transistor of appropriate power.

In the example illustrated, each switch S1, S2 includes a diode D1, D2 connected in parallel with the corresponding power transistor T1, T2. For example, each switch S1, S2 includes a gate electrode, respectively denoted G1 or G2, connected to the gate of the corresponding power transistor T1, T2.

In the example illustrated, an output terminal 4, also called AC terminal 4, is connected to a midpoint P between the negative electrode of the first transistor T1 and the positive electrode of the second transistor T2.

Advantageously, each of the connection terminals 6 and 8 comprises at least one contact pad, for example to facilitate the connection of said connection terminal with an external electrically conductive element, such as a cable, a laminated busbar or a connection bar.

In the illustrated example, the first terminal 6 has two first contact pads 61, 62, and the second terminal 8 has two second contact pads 81 and 82.

For example, the output terminal 4 also includes one or more such contact pads, here three in number and bearing the references 41, 42 and 43.

The device 2 also comprises an electronic control circuit 10 configured to control the first and second power switches S1, S2, more particularly to control and protect the switching of the transistors T1 and T2 as a function of a control signal.

According to examples, in order to control the switches S1 and S2, the control circuit 10 can be connected to control electrodes of the switches S1 and S2, in particular to the electrodes G1 and G2.

For example, according to embodiments, the control circuit 10 includes a microcontroller or a microprocessor programmed to execute instructions and/or software code stored in memory in a computer-readable medium, such as non-volatile memory, in order to implement one or more algorithms, in particular a method for controlling switches S1 and S2.

Alternatively, according to other embodiments, the control circuit 10 comprises a dedicated integrated circuit configured to implement said method.

According to examples, the electronic control circuit 10 is mounted on a printed circuit board 16, shown on figure 2.

In practice, components forming said electronic control circuit 10 are mounted on the printed circuit board 16 and are for example connected by cables or electrically conductive tracks formed on or in the printed circuit board 16.

For example, the printed circuit board 16 is a plate of planar shape and preferably rigid.

The device 2 also comprises a housing 18, shown on Figure 2. For example, the housing 18 is made of an insulating material such as a plastic, preferably a molded polymer, or a composite material. A part of the first circuit 5, in particular the first and second switches S1 and S2, is here housed inside the housing 18. The connection terminals 6 and 8, or possibly terminal 4 and the electrodes G1 and G2, are on the other hand arranged so as to be accessible from outside the housing 18. In particular, the housing 18 includes a main face 19 on which the first and second connection terminals 6 and 8 are arranged. For example, the main face 19 is an upper face of the housing 18.

According to the illustrated example, the housing 18 has a block shape, for example with a base portion of rectangular shape.

The control circuit 10 is arranged outside the housing 18. For example, the printed circuit board 16 on which the control circuit 10 is formed is mounted on the housing 18, for example attached to the exterior of the housing 18 while being fixed to it. Preferentially, the printed circuit board 16 is arranged on the main face 19.

According to embodiments, the device 2 is formed from a preformed electrical device, such as a power pack, in particular a semiconductor power module, to which the printed circuit board 16 is added. According to examples, the connection terminals 6, 8 are arranged side by side and preferably aligned in a same geometric plane P1, here parallel to the main face of the housing 18. In the example illustrated, said plane P1 is perpendicular to a vertical direction of the housing 18. For example, in the example illustrated, the connection terminals 6, 8 have a rectangular shape and are arranged parallel to an axis X passing through the plane P1, on either side of the axis X, this axis X being here horizontal and parallel to one of the edges of the housing 18.

Preferably, the first contact pads 61, 62 are aligned parallel to the axis X, and the same goes for the second contact pads 81, 82.

The printed circuit board 16 comprises two recesses 20 each of a shape complementary to the shape of the portion of the housing 18 on which the first contact pads 61, 62 are mounted. For example, the recesses each has an essentially rectangular shape or a polyhedron shape.

The printed circuit board 16 comprises at least one pad 22B protruding between the two recesses 20. In other words, the pad 22B is arranged between the first contact pads 61, 62 in the direction of the axis X.

The device 2 also comprises a detection apparatus comprising at least one coil 12 associated with the first 6 and second 8 connection terminals, and an electronic processing circuit 14 configured to detect an electrical voltage measured by said coil 12. This electric voltage is representative of the magnetic field measured by coil 12.

The coil 12 is mounted on the printed circuit board 16, and more particularly on the pad 22B, so it is mounted in a rectangular area delimited by the first 61, 62 and second 81, 82 contact pads. Thus, the coil 12 is arranged to measure the magnetic field existing between the terminals in said plane.

Preferentially, the coil 12 is arranged between the first contact pads 61, 62 in the direction of the axis X.

It should be noticed that there is a magnetic coupling between the first circuit 5 and the coil 12. Thus, current variation through the first circuit 5 generate a magnetic field, and the magnetic field is transformed by the coil 12 into a resulting voltage. By using this voltage information, it is possible to get several information, such as the current variation di/dt, the current level, etc. This information about the current variation di/dt allows optimizing the control of the first circuit 5.

According to examples, the coil 12 comprises one or more windings of an electrical conductor. The coil 12 can be a preformed coil, for example pre-wound on a preconstructed support, which is then mounted or welded on the printed circuit board 16. Alternatively, the coil 12 is formed directly on the printed circuit board 16, for example by depositing or printing or etching an electrically conductive material in or on the printed circuit board 16.

The processing circuit 14 is also formed on the printed circuit board 16. For example, according to embodiments, the processing circuit 14 includes a microcontroller or a microprocessor programmed to execute instructions and/or software code stored in memory in a computer-readable medium, such as non-volatile memory, in order to implement one or more algorithms, in particular a method for detecting an electrical voltage measured by said coil 12. Alternatively, according to other embodiments, the processing circuit 14 comprises a dedicated integrated circuit or a programmable logic component configured to implement said method.

In certain embodiments, at least part of the functions of the processing circuit 14 can be implemented by the control circuit 10. In other words, the processing circuit 14 and the control circuit 10 can then form one and the same electronic circuit or set of electronic circuits.

Optionally, the printed circuit board comprises three pads, which are a central pad 22B (corresponding to the previously disclosed pad), and two lateral pads 22A, 22C arranged on either side of the first contact pads 61, 62. Thus, as shown on the figure 2, the first contact pad 61 is between one of the lateral pads 22A and the central pad 22B, and the other first contact pad 62 is between the other of the lateral pads 22C and the central pad 22B.

Each of the three pads 22A, 22B, 22C is provided with a respective coil.

In a first variant, the three coils are independent from each other, and the electronic processing circuit 14 is configured to interpret independently the different voltages detected for each independent coil. The information from three different coils allows a better adjustment and more optimized control of the first circuit 5.

In another variant, the three coils are connected together, so that the electronic processing circuit 14 is configured to interpret the voltage from the assembly of coils in a same manner as if there is only one coil. This solution provides higher voltage levels, making it easier to handle in a disturbed environment. Figure 2 shows the optional two lateral pads and lateral coils, but an embodiment with only the central coil is possible.

## Claims

1. An electronic power device (2), comprising:
- a first power switch (S1) and a second power switch (S2) connected in series between first (6) and second (8) connection terminals of the device (2),
- a detection apparatus comprising at least one coil (12) associated with the first and second connection terminals, and an electronic processing circuit (14) configured to detect an electrical voltage measured by said coil (12),
**characterized in that** said coil (12) is mounted on a printed circuit board (16) adjacent said first (6) and second (8) connection terminals and aligned, substantially in the same geometric plane as said printed circuit board (16),
and **in that** the coil (12) is configured to measure the magnetic field existing between said terminals (6, 8) in said plane (P1).

2. The electronic power device (2) according to claim 1, comprising a housing (18) in which the first and second switches (S1, S2) are housed, and including a main face (19) on which the first (6) and second (8) connection terminals are arranged, the printed circuit board (16) being arranged on said main face (19).

3. The electronic power device (2) according to claim 1 or 2, wherein the first terminal (6) comprises two first contact pads (61, 62), and the second terminal (8) comprises two second contact pads (81, 82).

4. The electronic power device (2) according to claim 3, wherein the coil (12) is arranged in an area delimited by the two first contact pads (61, 62) and the two second contact pads (81, 82).

5. The electronic power device (2) according to claim 4, wherein the coil (12) is aligned with the printed circuit board (16) or mounted on its surface.

6. The electronic power device (2) according to claim 4 or 5 taken in combination with claim 2, wherein the printed circuit board (16) comprises two recesses (20) each of a shape complementary to the shape of a portion of the housing (18) on which the first contact pads (61, 62) are mounted.

7. The electronic power device (2) according to claim 6, wherein the printed circuit board (16) comprises a pad (22) protruding between the two recesses (20), the coil (12) being arranged on the pad (22).
